(19)

Europäisches
Patentamt
European
Patent Office
Office européen
des brevets

(11) **EP 1 496 610 B1**

(12) **EUROPEAN PATENT SPECIFICATION**

(45) Date of publication and mention
of the grant of the patent:
**05.10.2011 Bulletin 2011/40**

(51) Int Cl.:
**H03C 3/40** *(2006.01)*

(21) Application number: **04447165.4**

(22) Date of filing: **07.07.2004**

(54) **Frequency converter with carrier self-mixing suppression**

Frequenzumsetzer unter Verwendung von Unterdrückung der Trägerselbstmischung

Convertisseur de fréquence utilisant la suppression du mélange autodyne de la porteuse

(84) Designated Contracting States:
**AT BE BG CH CY CZ DE DK EE ES FI FR GB GR
HU IE IT LI LU MC NL PL PT RO SE SI SK TR**

(30) Priority: **07.07.2003 EP 03447180**

(43) Date of publication of application:
**12.01.2005 Bulletin 2005/02**

(73) Proprietor: **IMEC**
**3001 Leuven (BE)**

(72) Inventor: **Craninckx, Jan**
**3370 Boutersem (BE)**

(74) Representative: **Luys, Marie-José A.H. et al**
**Gevers**
**Intellectual Property House**
**Holidaystraat 5**
**1831 Diegem (BE)**

(56) References cited:
**EP-A- 0 477 720      EP-A- 1 172 928**
**EP-A2- 1 047 185      WO-A-00/59171**
**US-A- 5 918 167**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to an electrical device comprising analog conversion circuitry for converting signals from a first frequency range to a second frequency range, in particular an analog transmit device, such as for example a direct upconversion transmitter. The invention further relates to a method for deriving characteristics of such a device and precompensating an input signal of such a device.

The direct upconversion (or zero-IF) transmitter is the transmitter architecture which is most probably used in wireless transceivers. In such a transmitter, two mixers are driven by baseband (BB) and local oscillator (LO) signals, which are in quadrature. Ideally, combining the two signal paths as $BB_I \cdot LO_I - BB_Q \cdot LO_Q$ gives a single output frequency $\omega_{LO} + \omega_{BB}$. However, there are analog imperfections such as DC offsets ($\delta_{BBi,q}$, $\delta_{Loi,q}$), LO-to-RF feedthrough ($\sigma_{LOi}$, $\sigma_{LOq}$), and quadrature amplitude ($\varepsilon_{BB}$, $\varepsilon_{LO}$) and phase ($\Delta\phi_{BB}$, $\Delta\phi_{LO}$) errors. This results in an output spectrum which contains also an image and a carrier signal. High-end telecom systems such as WLAN require a high suppression of these spurs. In order to determine the exact origin and contribution of the analog non-idealities to this output spectrum, the amplitude and phase of each spur must be known. In the prior art, this is done by downconverting the RF spectrum back to baseband with a substantially ideal receiver, i.e. an expensive device which has a substantially higher conversion accuracy than the transmitter, which is necessary since otherwise the measurement will be as erroneous as the errors which are to be determined. So this method is not viable for automatic calibration.

Furthermore, up to now only techniques using the amplitude information are known. This amplitude information is obtained by placing a peak detector at the RF output [M. Faulkner, T. Mattsson, and W. Yates, "Automatic adjustment of quadrature modulators", IEE Electronic Letters, vol. 27, no. 3, pp. 214-215, Jan. 1991] or by monitoring the power in the adjacent channel [D. Hilborn, S. Stapleton, and J. Cavers, "An adaptive direct conversion transmitter", IEEE Trans. On Vehicular Technology, vol. 43, no. 2, pp. 223-233, May 1994]. As no phase information on the spurs is available, a time-consuming recursive "trial-and-error" algorithm is always needed in order to determine the optimal baseband corrections which result in the smallest error.

Transmit devices including calibration means are further known from EP 0477720, WO 00159171, EP 1172928, US-A-5918167 and EP-A-1047185.

There is thus a need for a direct upconversion transmitter which can be calibrated without needing an expensive ideal receiver and for a method with which the device characteristics or non-idealities can be determined and compensated in a simpler way, avoiding a time-consuming recursive algorithm. Since the non-idealities of a direct upconversion transmitter largely originate from the frequency conversion circuitry which is used and such frequency conversion circuitry is also used in other electrical devices, there is in fact a more general need to provide any electrical device which comprises frequency conversion circuitry with a means for more simply and less expensively deriving the device characteristics, and to provide a simpler method for deriving and compensating the characteristics of such a device.

It is therefore an aim of the invention to provide an electrical analog transmit device, a method for determining device characteristics and a method for compensating the characteristics which fulfil the above mentioned needs.

This aim is achieved according to the invention with an electrical analog transmit device according to claim 1, a method for determining device characteristics according to claim 8 and a method for precompensating device characteristics according to claims 12.

The electrical analog transmit device of the invention comprises analog conversion circuitry having an input and an output, which is essentially provided, i.e. intended for converting a first input signal within a first frequency range applied to its input to a first output signal within a second frequency range above the first frequency range at its output. The device further comprises signal adding means for adding a portion of the first output signal as second input signal to the first input signal. This means that a portion of the output of the conversion circuitry, i.e. a portion of the signal within the second frequency range is supplied back to the input of the conversion circuitry. The conversion circuitry is also capable of converting this second input signal, which is within the second frequency range, back to the first frequency range. Finally, characteristic deriving means are provided for deriving at least one characteristic of the electrical device from the frequency converted second input signal, which appears at the output of the conversion circuitry.

By supplying a portion of the output signal back to the input of the conversion circuitry, in the end a signal portion is achieved at the output of the conversion circuitry, namely the frequency converted second input signal, which has been converted from the first frequency range to the second frequency range and back to the first frequency range with the same device. As a result, this signal portion is twice subjected to the same non-idealities. From a comparison with the initial input signal, i.e. a comparison of the frequency converted second input signal with the first input signal, the double influence of these non-idealities on the signal during conversion can be determined and one or more device characteristics can be derived.

In the device of the invention, a portion of the output signal of the conversion circuitry, - is converted back to the initial frequency range by re-using the same device, so without introducing an influence of non-idealities of a second conversion device. As a result, the need for providing an expensive conversion device which is more ideal or more accurate than the conversion circuitry is avoided. Furthermore, however ideal or accurate such a second conversion device may be, it may still further deteriorate the signal, so by converting the output signal back with the same device also such deterioration is avoided, so that the device characteristics can be determined more accurately.

The signal adding means for adding a portion of the output signal as second input signal to the first input signal is formed by an electrical connection from the output towards the input of the conversion circuitry. This connection comprises one or more circuit blocks, namely at least one or more filters for eliminating signals outside the second frequency range from the output signal, and possibly a phase shifter for invoking one of a plurality of predetermined phase shifts to the second input signal before being added to the first input signal.

Analogously, the method of the invention for determining device characteristics comprises the steps of (a) supplying the first input signal to the device, (b) eliminating signals outside the second frequency range from the output signal for creating a portion of the output signal and adding said portion of the output signal as a second input signal to the first input signal, and (c) extracting a first frequency range portion from the output signal and deriving at least one characteristic of the electrical analog transmit device from the frequency converted second input signal. The method of the invention for precompensating an input signal further comprises the step of precompensating the input signal on the basis of the determined device characteristics. This precompensation is preferably performed in the digital domain.

The invention will be further elucidated by means of the following description and the appended figures.

Figure 1 shows a schematic representation of a transmit device comprising frequency conversion circuitry according to the invention.
Figure 2 shows a schematic representation of a receiver device comprising frequency conversion circuitry.
Figure 3 shows a direct upconversion transmitter architecture (prior art).
Figure 4 shows a standard circuit diagram for an upconversion mixer (prior art).
Figure 5 shows the typical output spectrum of a direct upconversion mixer.
Figure 6 shows an embodiment of a direct upconversion transmitter architecture according to the invention.
Figure 7 shows a possible circuit implementation of an upconversion mixer according to the invention.
Figure 8 shows a block diagram for baseband calibration of the device of figure 6.
Figure 9 shows a block diagram for time-domain baseband precompensation of the device of figure 6.
Figure 10 shows a possible circuit implementation for baseband calibration of the upconversion mixer of figure 7.
Figure 11 shows a possible circuit implementation for feedback DC offset calibration of the upconversion mixer of figure 7.
Figure 12 shows a possible circuit implementation for AC-coupling the feedback inputs of the upconversion mixer of figure 7.

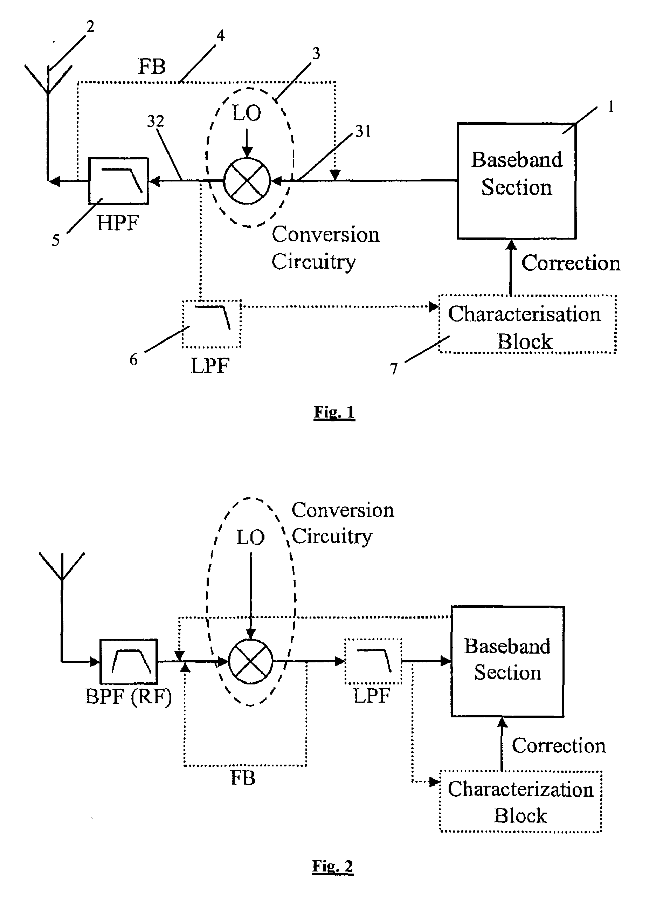

The invention is generally applicable to any electrical analog transmit device having analog conversion circuitry which is essentially provided for performing a frequency conversion on a first input signal within a first frequency range to obtain an output signal within a second frequency range above the first frequency range. Such an electrical device is shown in Fig. 1.

The device of Fig. 1 is an analog transmit device, which has analog conversion circuitry for converting a baseband input signal to an RF output signal. The additional components of the device of Fig. 1 with respect to a known analog transmit device are shown in dotted lines. The baseband input signal is supplied to the conversion circuitry from a baseband section. The output signal of the conversion circuitry is supplied to an RF section for transmittal. The conversion circuitry may comprise one or more conversion steps, each formed by a local oscillator LO and a mixer. A portion of the output signal of the conversion circuitry is added onto the baseband input signal by means of signal adding means, which are formed by an electrical connection FB in Fig. 1, but other means may also be provided for this purpose. This has the effect that an RF second input signal is supplied to the input of the conversion circuitry, which is downconverted to a baseband portion in the output signal. This baseband portion is the result of an upconversion and a downconversion by the same conversion circuitry, so by measuring the baseband portion and comparing it with the baseband input signal, characteristics of the conversion circuitry can be determined.

The baseband portion is conveniently extracted from the output signal by means of a low pass filter LPF or alternative means and supplied to a characterisation block, which is provided for deriving the desired device characteristics and supplying signal correction data to the baseband section. The output signal which is supplied to the RF section is also filtered, namely by means of a filter HPF for eliminating signals outside the RF frequency range, so that unwanted components are removed before transmittal.

In the transmit device of Fig. 1, the electrical connection FB also comprises a filter for eliminating signals outside the RF frequency range from the output signal, which is conveniently formed by the filter HPF of the RF section. The connection FB may further comprise a phase shifter (not shown) for invoking one of a plurality of predetermined phase shifts to the second input signal. The phase shifter may conveniently be an RC/CR block, as will appear from the following. Of course the connection FB may comprise further components, but it is preferred to keep their number as low as possible, since each component may introduce further non-idealities.

The device of figure 2 is outside the scope of the invention, but is described for the purposes of understanding the invention. The device of Fig. 2 is an analog receiver device, which also has analog conversion circuitry, but for converting an received RF signal to a baseband signal. The conversion circuitry may comprise one or more conversion steps, each formed by a local oscillator LO and a mixer. The additional components of the device of Fig. 2 with respect to a known analog receiver device are shown in dotted lines. An RF section, which during normal operation receives RF signals, is connected on the input of the conversion circuitry via an RF centered band pass filter BPF, which eliminates components outside the RF frequency range. A baseband section, which is connected to the output of the conversion circuitry, is also provided for supplying a baseband input signal to the input of the conversion circuitry for calibration purposes. This is shown in Fig. 2 by means of the arrow connecting the baseband section to the input (the RF side) of the conversion circuitry. At least a portion of the output signal of the conversion circuitry is added onto the baseband input signal by means of signal adding means, which are formed by an electrical connection FB in Fig. 2, but other means may also be provided for this purpose. Again, this has the effect that an RF second input signal is supplied to the input of the conversion circuitry and added onto the first, baseband input signal. The second input signal is downconverted back to a baseband output signal, which is the result of an upconversion and a downconversion by the same conversion circuitry. So by extracting and measuring the baseband output signal and comparing it with the baseband input signal supplied from the baseband section, characteristics of the conversion circuitry can be determined.

In the device of Fig. 2, the baseband output signal is extracted from the output signal by means of a low pass filter LPF or alternative means, which eliminates the RF components from the output of the conversion circuitry. The baseband output signal is then supplied to a characterisation block, which is provided for deriving the desired device characteristics and supplying signal correction data to the baseband section.

In the device of Fig. 2, the baseband section is also connected to the output of the conversion circuitry via the low pass filter LPF, which is thus conveniently used during calibration as well as during normal operation of the device. During calibration, a switch can for example disconnect the baseband section.

The electrical connection FB may further comprise a phase shifter (not shown) for invoking one of a plurality of predetermined phase shifts to the second input signal. The phase shifter may conveniently be an RC/CR block. Of course the connection FB may comprise further components, but it is preferred to keep their number as low as possible, since each component may introduce further non-idealities.

In the following, the invention is applied to the example of a direct upconversion (or zero-IF) analog transmitter, which is used in most modern integrated transceiver systems. It is understood that the invention can more generally be applied in any electrical analog transmit device which has analog frequency conversion circuitry.

In the following, the signal adding means, i.e. the connection line or alternative means which add the portion of the output signal of the conversion circuitry onto the input signal, are referred to as feedback circuitry. This terminology is relevant, since the output is (partly) "fed back" to the input, but it should be noted that such terminology is generally used to refer to circuitry which actually measure the output and apply a correction to the source, much like the characterisation block in Figs. 1 and 2.

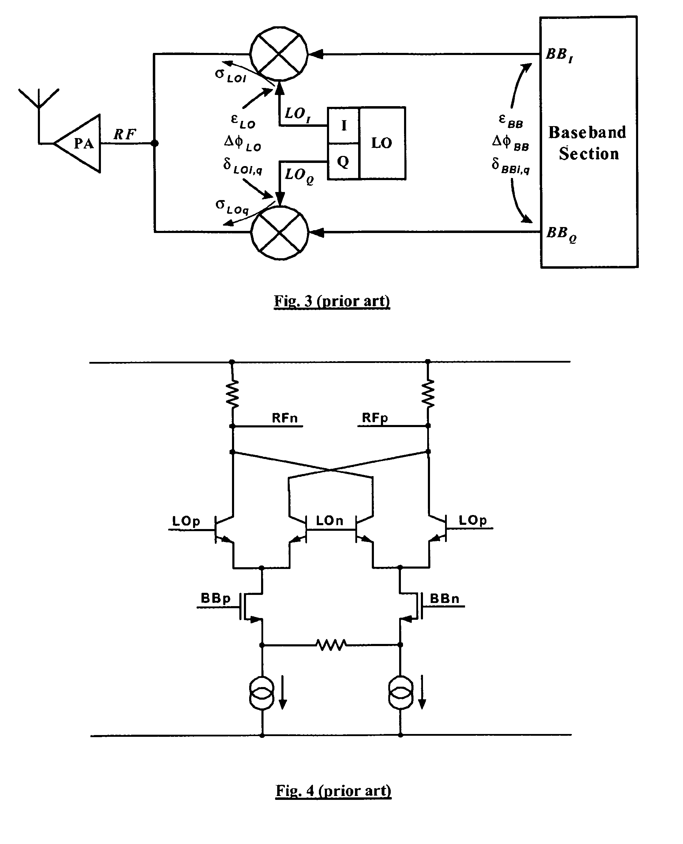

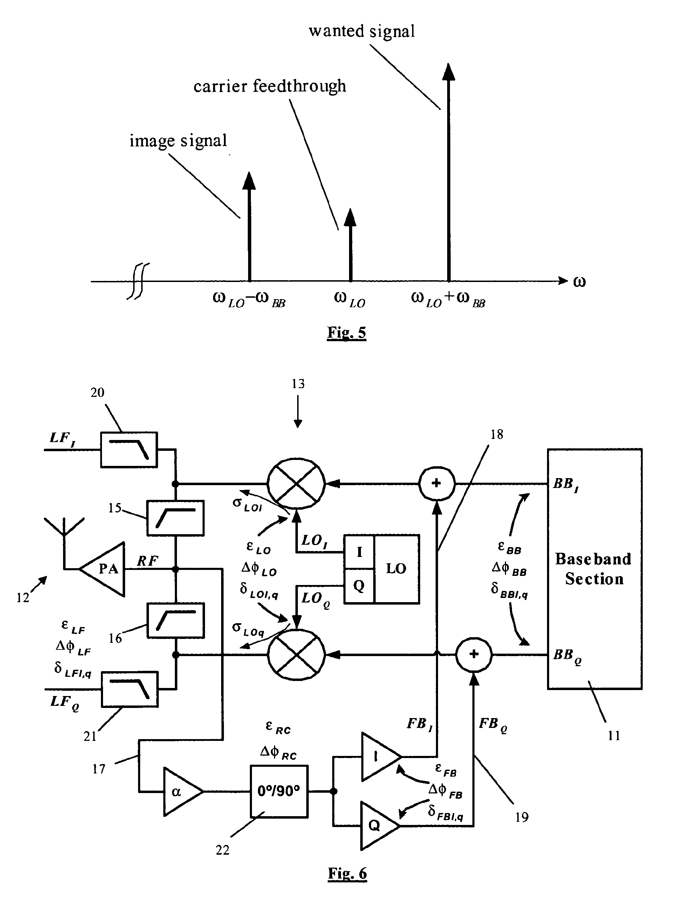

A known direct upconversion transmitter is shown in Fig. 3. A standard circuit diagram for the mixer block is shown in Fig. 4 and a typical output spectrum of a direct upconversion mixer is shown in Fig. 5. The two mixers are driven by baseband (BB) and local oscillator (LO) signals that are in quadrature. If all circuits are perfectly matched, the RF output signal is given by

$$RF = LO_I \cdot BB_I - LO_Q \cdot BB_Q$$
$$= \cos(\omega_{LO} \cdot t) \cdot \cos(\omega_{BB} \cdot t) - \sin(\omega_{LO} \cdot t) \cdot \sin(\omega_{BB} \cdot t) \qquad (1)$$
$$= \cos((\omega_{LO} + \omega_{BB}) \cdot t)$$

The two signals add up constructively for the wanted sideband and destructively for the unwanted sideband, which results indeed in the desired single sinewave at frequency $\omega_{LO} + \omega_{BB}$.

Although this architecture is almost ideally suited for this purpose, it has the drawback over heterodyne upconverters of generating some in-band spurs that cannot be eliminated by appropriate RF filtering. The most important spurs are located on the image frequency (due to imperfect image rejection) and on the carrier frequency (due to DC offsets and LO-to-RF feedthrough). The two quadrature paths (I and Q) are not perfectly matched, and real implementations of this circuit will have mismatches in amplitude ($\varepsilon$) and phase ($\Delta\phi$) and dc offsets ($\delta$). We can describe the complex baseband signal of amplitude $A_{BB}$, frequency $\omega_{BB}$ and phase $\theta_{BB}$ with the following equations:

$$V_{BBi} = A_{BB} \cdot (1 + \varepsilon_{BB}) \cdot \cos(\omega_{BB} \cdot t + \theta_{BB} + \Delta\phi_{BB}) + \delta_{BBi}$$
$$V_{BBq} = A_{BB} \cdot (1 - \varepsilon_{BB}) \cdot \sin(\omega_{BB} \cdot t + \theta_{BB} - \Delta\phi_{BB}) + \delta_{BBq}$$
$$(2)$$

The baseband signal is upconverted to RF by the quadrature LO signals

$$V_{LOi} = A_{LO} \cdot (1 + \varepsilon_{LO}) \cdot \cos(\omega_{LO} \cdot t + \theta_{LO} + \Delta\phi_{LO}) + \delta_{LOi}$$
$$V_{LOq} = A_{LO} \cdot (1 - \varepsilon_{LO}) \cdot \sin(\omega_{LO} \cdot t + \theta_{LO} - \Delta\phi_{LO}) + \delta_{LOq}$$
$$(3)$$

Errors in amplitude and phase result in the generation of an image component at frequency $\omega_{LO} - \omega_{BB}$ with a magnitude in dBc given by

$$P_{image} = 20 \cdot \log(\tan(\Delta\phi))$$
$$= 20 \cdot \log(\varepsilon)$$
$$(4)$$

So an amplitude error of 2% generates in image component of -34dBc, and the image rejection with a phase error of 3° is only 25dB. So in order to be able to comply with the transmitter requirements of high-datarate communication systems such as OFDM WLAN, a calibration scheme is required. DC offsets in the baseband signal generate a carrier component that must also be limited to comply with the spectral mask specifications. Again, a DC offset of 2% results in a carrier component of -34dBc. But more importantly this carrier feedthrough is also created by direct LO-to-RF feedthrough in the mixers, as indicated with the contributions $\sigma_{LOi}$ and $\sigma_{LOq}$ in Fig. 3.

In applying the invention to the direct upconversion transmit architecture, as proposed in Fig. 6, the basic idea is to downconvert the RF signal back to baseband, but doing this by re-using the transmit mixers for the downconversion function. Again, errors will be made in this downconversion, but this time the errors in the up- and downconversion are correlated, so the required measurements and equations to calculate them can be derived. For example, the quadrature error in the downconversion will be the same as in the upconversion, so the actual error will be half of the quadrature error which is measured on the downconverted signal.

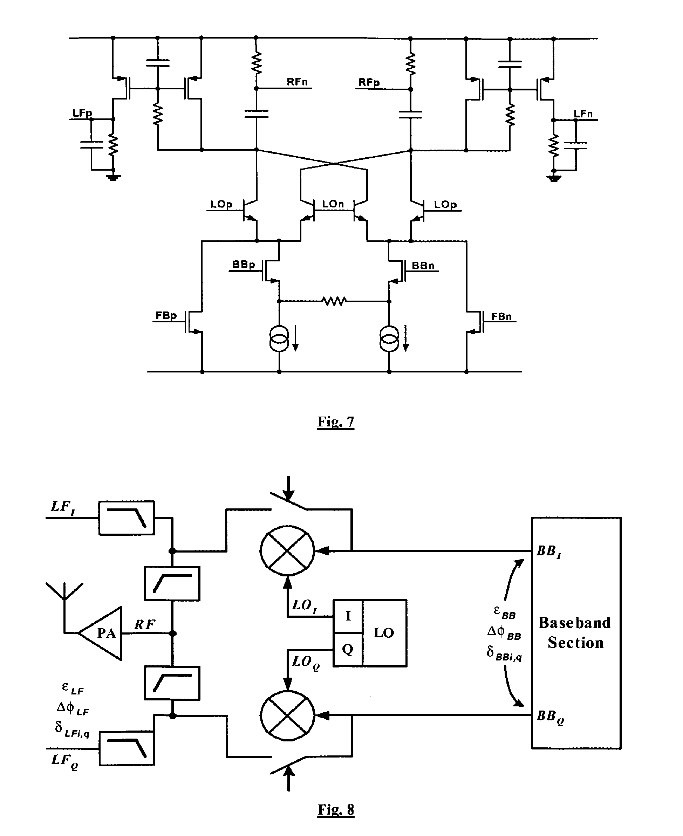

Thorough investigation of this idea shows that, although at first sight very simple, retrieving the TX errors requires some more operations than this. The main reason is that there are a lot of unknown and uncertain phase shifts in the RF path, which complicate the mathematical formulas. The final circuit topology that allows to successfully recover all errors is shown in Fig. 7. By comparison with the standard circuit topology of Fig. 4, the additional components are immediately clear. The standard upconversion operation passes the LOxBB signal through a high-pass filter to the RF port. In the circuit of Fig. 7, a fraction $\alpha$ of the RF signals is tapped and fed back to the BB input ports of the TX mixers. This will create an RFxLO=BB component in the output spectrum, which passes through a low-pass filter and is measured at the LF ports. This signal can be amplified and converted to the digital domain (e.g. by the receive VGA and ADC already present in the system), where the necessary calculations required for determining the quadrature errors can be performed.

An RC phase shifter generating the FB signal with either 0 or 90 degrees delay is inserted for obtaining two output signals which make it possible to perform all the mathematical operations for retrieving two LO quadrature errors $\varepsilon_{LO}$ and $\Delta\phi_{LO}$. All the added blocks are however also not perfectly matched and they have quadrature errors associated with them as indicated in the Fig. 6. A possible circuit implementation of a mixer including the low- and high-pass filtering in the output path and the extra feedback inputs in parallel with the baseband inputs is shown in Fig. 7.

Of course, all the extra circuitry is not free from nonidealities, and will introduce errors in the calibration measurements which are performed. These errors are also indicated in Fig. 6. They include:

- quadrature errors ($\varepsilon_{FB}$ and $\Delta\phi_{FB}$) and DC offsets ($\delta_{FBi}$ and ($\delta_{FBq}$) in the feedback signals $FB_I$ and $FB_Q$
- quadrature errors ($\varepsilon_{LF}$ and $\Delta\phi_{LF}$) and DC offsets ($\delta_{LFi}$ and $\delta_{LFq}$) in the low-frequency signals $LF_I$ and $LF_Q$
- amplitude and phase errors ($\varepsilon_{RC}$ and $\Delta\phi_{RC}$) in the 90-degree rotation in the feedback path.

In the following calibration procedure, sufficient measurements and mathematics are employed to cancel out the effect of these extra imperfections, and acquire a good estimation for the errors in the baseband and local oscillator signals.

Below it is described how the feedback circuitry can be used to automatically calibrate the transmit spectrum, at regular times before actually transmitting data. Several measurements are performed, making regular use of switches or multiplexers that guide low-frequency signals from one part of the circuit to another. Care must be taken to design these multiplexers such that they do not influence the measurement. Preferably, multiplexing is done in the current domain and simple CMOS pass transistors can be used to switch the signal from one node to another. The calculations presented make use of the FFT function, a block that comes for free in e.g. an OFDM modem since the receiver is not running at this moment. For other applications where such an FFT is not readily available, other mathematic derivations can be analogously developed.

The complete calibration sequence is performed in 6 steps, as set out below.

Step 1: Calibrate the BB signal

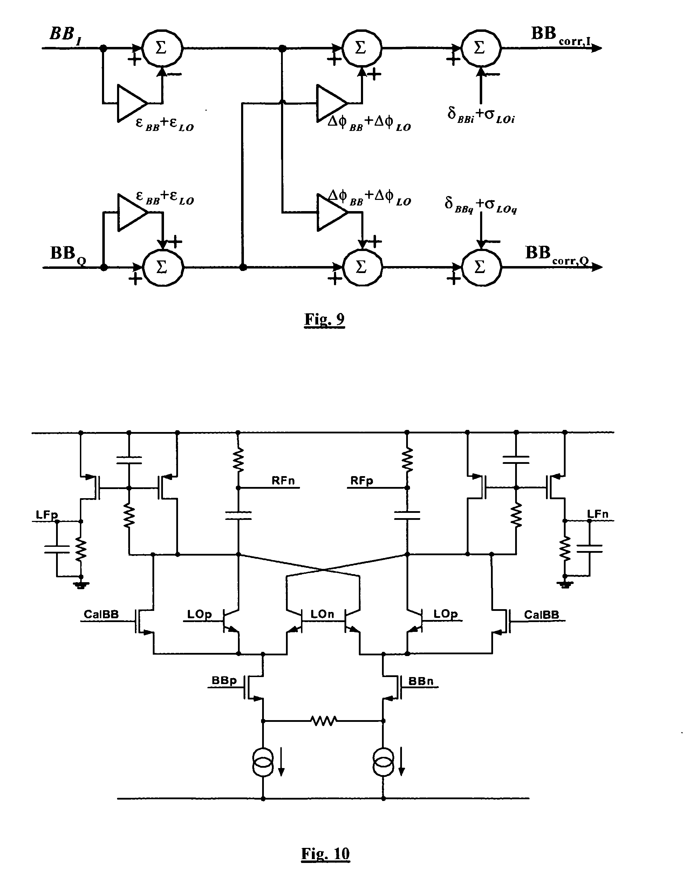

In this step a sine wave BB signal is applied to the mixer, but the circuit is put in a configuration where it does not perform an upconversion. Instead the baseband signal is transferred directly to the output, where it takes the path through the low-pass filter and is detected at the LF outputs. A block diagram for this is shown in Fig. 8 and a possible circuit implementation for this is shown in Fig. 10. The LO signal can be running, but the DC level of the LO mixer transistors is set to ground to completely eliminate the mixing operation. This way the BB current signal is directed towards the LF outputs. An alternative would be to apply no LO signal, and shift only the DC level of the inner mixer transistors (driven by the signal LOn) to zero, while the outer transistors stay active and conduct the BB current without any mixing operation to the output.

In order to cancel the quadrature error of the LF path ($\varepsilon_{LF}$ and $\Delta\phi_{LF}$) (both in the filter circuitry shown and in the following amplifiers and A-to-D converters), two measurements must be done with I and Q signals swapped:

- $BB_I$ signal to $LF1_I$ signal and $BB_Q$ current to $LF1_Q$ signal
- $BB_I$ signal to $LF2_Q$ signal and $BB_Q$ current to $LF2_I$ signal

And in order to cancel the DC offsets in the LF path ($\delta_{FBi}$ and $\delta_{FBq}$) a third measurement is required with the sign of the BB signals swapped:

- $-BB_I$ signal to $LF3_I$ signal and $-BB_Q$ current to $LF3_Q$ signal Since all these switches (only one pair CalBB is shown in Figs. 8 and 10) are done in the current domain, the influence of imperfect matching in the switches should be negligible.

To determine the BB quadrature errors, the first two measurements can be combined:

$$LF_I = LF1_I + LF2_Q$$
$$LF_Q = LF1_Q + LF2_I$$

$$(5)$$

and the FFT of the complex signal $LF_I + j.LF_Q$ is taken that will contain three spectral components:

- one at frequency $+\omega_{BB}$ with a complex amplitude $A+j.B$
- one at frequency $-\omega_{BB}$ with a complex amplitude $C+j.D$
- one at DC with a complex amplitude $E+j.F$

The DC component does not contain any useful information since the DC offsets off the LF path are still included. From the other numbers the quadrature errors of the BB signal can be calculated with these equations:

$$\varepsilon_{BB} = \frac{C \cdot A - D \cdot B}{A^2 + B^2}$$

$$\Delta\phi_{BB} = -\frac{C \cdot B + D \cdot A}{A^2 + B^2}$$

$$(6)$$

It is also possible to apply a multi-tone BB signal and in this way determine the frequency-dependent BB quadrature errors. These will be rather important because e.g. mismatch in the anti-alias filter after the D-to-A converter will shift the position of the filter poles, and so generate a different amplitude and phase response in the I and Q path.

In the extreme case for the WLAN OFDM system, a BB signal with 26 carriers at all positive frequencies nx312.5kHz can be applied, and for each component the resulting signal at the negative frequency (given by the FFT component C+*j.D*) gives the quadrature error information. Care must be taken however that harmonic distortion components from e.g. carrier x do not disturb the measurements at carriers 2x, 3x, etc. Therefore it is preferred that only a limited number of BB carriers are applied, whose frequencies are chosen such that the harmonic distortion components do not fall on top of other fundamental frequencies. The quadrature errors of the other (non-used) carriers can easily be retrieved from interpolation between the known points. Also the phases of the applied carriers must be chosen such that the generation of signals with high crest factors is avoided.

Next the baseband DC offsets are determined by combining the first and the third measurements:

$$LF_I = LF1_I - LF3_I$$
$$LF_Q = LF1_Q - LF3_Q \qquad (7)$$

and taking the average (DC) value of them gives

- average of $LF_I = G$
- average of $LF_Q = H$

from which the baseband DC offsets can be calculated:

$$\delta_{BBi} = \frac{G}{\sqrt{A^2 + B^2}}$$
$$\delta_{BBq} = -\frac{H}{\sqrt{A^2 + B^2}} \qquad (8)$$

As there normally is a programmable gain implemented in the transmit baseband circuitry to provide a certain amount of RF power control, it is possible that dc offset and/or quadrature errors might be dependent on the TX baseband gain. In that case, step 1 might have to be repeated for the different possible gain settings, or a subset thereof.

Step 2 : FB DC offset calibration

Next the DC offset in the feedback path must be measured. This is necessary because later we will activate them to feedback the RF signal to the LF ports, and the DC signal present at the LF ports will be used as an estimation of the carrier spectrum of the RF output. If however this feedback path inserts also DC offset, a false carrier component will be generated and the actual LO feedthrough will be incorrectly compensated for.

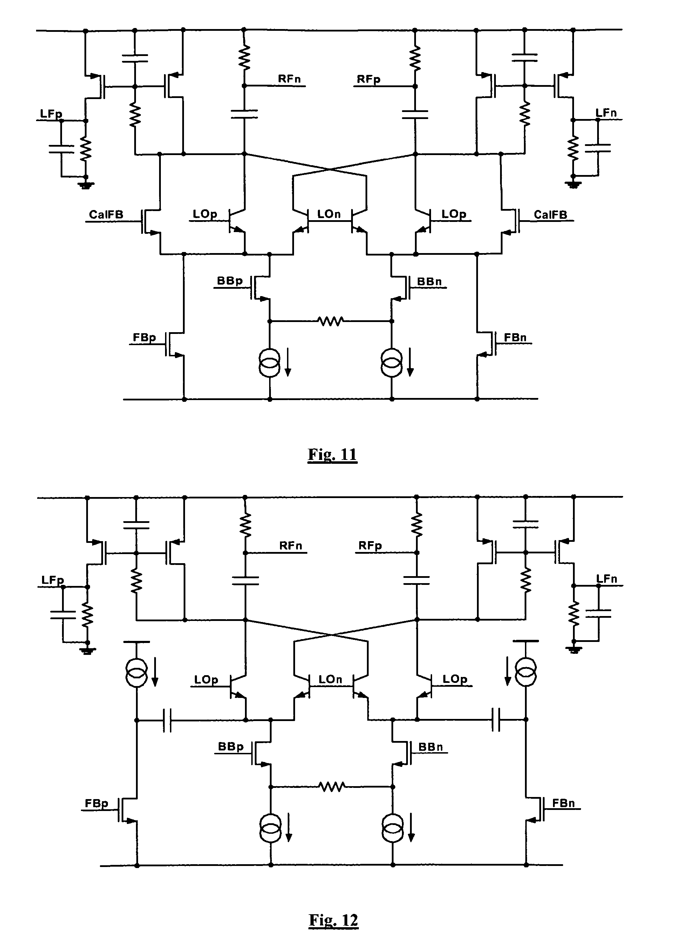

For this, the feedback circuitry is activated, but no RF signal is applied to it. The digital TX block, taking into account the previously estimated DC offset, must generate a zero baseband signal. As for the baseband calibration, the LO transistors of the mixer must be biased at ground level and are short-circuited by a switch leading the FB signal directly towards the LF ports. A possible circuit is shown in Fig. 11.

In order to cancel the DC offsets in the LF path ($\delta_{FBi}$ and $\delta_{FBq}$), two measurements are required with the sign of the FB signals swapped:

- $FB_I$ signal to $LF1_I$ signal and $FB_Q$ current to $LF1_Q$ signal
- $-FB_I$ signal to $LF1_I$ signal and $-FB_Q$ current to $LF2_Q$ signal

and taking the average (DC) value of the difference between these two measurements gives

- average of $LF_I - LF2_I = G$
- average of $LF1_Q - LF2_Q = H$

from which the feedback DC offsets can be calculated:

$$\delta_{FBi} = \frac{G}{\sqrt{A^2 + B^2}}$$

$$\delta_{FBq} = -\frac{H}{\sqrt{A^2 + B^2}}$$

(9)

Alternatively (and even preferably) a feedback circuit can be built that does not generate any DC offset, e.g. by simple AC coupling (or high-pass filtering) the feedback connection to the mixer input. An example circuit for a Gilbert-cell upconversion mixer is shown in Fig. 12. In this case it is not needed to calibrate out the feedback DC offset, saving the two measurements in step 2. And even more, also the third measurement of step 1 can be omitted because in the next step the LO-to-RF feedthrough is estimated. If there is a baseband DC offset, it will be combined with the LO-to-RF feedthrough and be compensated for in the same way. Of course, the baseband DC offset can be dependent on the baseband gain setting, so one must be careful in choosing the set of measurements to do.

Step 3: Calibrate local oscillator DC offset

Because DC offsets in the LO signal pass a fraction of the baseband signal directly to the mixer output, an error will be introduced in the measurements in steps 4 and 5. This error is measured now in order to cancel its contribution later.

For this a single BB tone is applied, preferably the one of a low frequency. It should have no quadrature errors or DC offsets, so the results of step 1 should already be applied now. It should also be generated with zero phase, i.e. the delay through the BB path, the LF measurement and the FFT calculation should be compensated for. This can easily be done by calculating the phase of the BB signal in step 1 ($\theta_{BB}$ = arctan(B/A)) and applying this value.

For the baseband DC offset, as explained before, one is free to compensate them at this point or do a combined estimation in this step of BB DC offsets ($\delta_{BBi,q}$) and LO-to-RF feedthrough ($\sigma_{LOi,q}$) in steps 4, 5 and 6.

The mixer now operates normally and shifts this baseband signal towards RF frequencies, but also generates some low-frequency signals. Two measurements are performed to cancel out quadrature errors in the LF path:

- output of mixer I to LF1$_I$ signal and output of mixer Q to LF1$_Q$ signal
- output of mixer I to LF2$_Q$ signal and output of mixer Q to LF2$_I$ signal

These waveforms contain information on the DC offsets in the LF path and the LO path. One could try to calculate these numbers based on the FFT results. A more efficient method captures these waveforms over a time interval of one period and stores for later use.

Step 4: First RF measurement

The same BB signal as in step 3 is applied. The mixer now operates normally and shifts this baseband signal towards RF frequencies.

But now the feedback path FB is also activated with the 0-degree delay setting, which causes the circuit to generate a low-frequency component that will be measured at the LF outputs. The delay setting at 0° is just a relative number, there are other phase shifts in the RF section which are unknown now but which will be cancelled out by the final mathematic formulas.

Again two measurements are done to cancel out the quadrature errors of the LF path.

- output of mixer I to LF1$_I$ signal and output of mixer Q to LF1$_Q$ signal
- output of mixer I to LF2$_Q$ signal and output of mixer Q to LF2$_I$ signal

The waveforms obtained in step 3 are subtracted from those obtained here. This effectively eliminates the errors due to DC offsets in the LF and the LO signals.

To estimate the LO quadrature errors and LO-to-RF feedthrough components, the FFT of the complex signal $(LF1_I + LF2_Q) + j.(LF1_Q + LF2_I)$ is taken, which contains three spectral components:

- one at frequency $+\omega_{BB}$ with a complex amplitude *A1+j.B1*
- one at frequency $-\omega_{BB}$ with a complex amplitude *C1+j.D1*
- one at DC with a complex amplitude *E1+j.F1*

It turns out that there are still too many unknowns in the system and not enough equations to solve them. Therefore a second RF measurement is needed.

Step 5: Second RF measurement

This step is a copy of step 4, but now the feedback delay is set to 90 degrees. This phase shifter does not have to be a very good one, because if the phase difference is not exactly 90° or if the amplitude does not remain equal, this can be detected in the LF signal and the final mathematics used in step 5 to estimate the errors will take this into account. So a single RC/CR phase shifter is sufficient for this purpose.

Again, two measurements (to cancel LF quadrature errors), subtraction of the waveforms of step 3 (to cancel LF and LO DC offsets), and the FFT of the average of the two obtained signals will result in three spectral components:

- one at frequency $+\omega_{BB}$ with a complex amplitude *A2+j.B2*
- one at frequency $-\omega_{BB}$ with a complex amplitude *C2+j.D2*
- one at DC with a complex amplitude *E2+j.F2*

Step 6: Mathematical calculations

The following formulas are able to give a good approximation of the LO quadrature errors:

$$\varepsilon_{LO} = \frac{(D2 \cdot B1 - D1 \cdot B2) + (C2 \cdot A1 - C1 \cdot A2)}{2 \cdot (A2 \cdot B1 - A1 \cdot B2)}$$
$$\Delta\phi_{LO} = \frac{(C2 \cdot B1 - C1 \cdot B2) - (D2 \cdot A1 - D1 \cdot A2)}{2 \cdot (A2 \cdot B1 - A1 \cdot B2)} \quad (10)$$

The carrier feedthrough amplitude and phase are given by the equations

$$\sigma_{LOi} = \frac{E2 \cdot B1 - E1 \cdot B2}{A2 \cdot B1 - A1 \cdot B2}$$
$$\sigma_{LOq} = \frac{F2 \cdot B1 - F1 \cdot B2}{A2 \cdot B1 - A1 \cdot B2} \quad (11)$$

An almost perfectly compensated RF output spectrum is obtained now by digitally precompensating the baseband signal with these estimations as follows:

$$BB_{corr,i} = (1 - \varepsilon_{BB} - \varepsilon_{LO}) \cdot \cos(\omega_{BB} \cdot t - \Delta\phi_{BB} - \Delta\phi_{LO}) - (\delta_{BBi} + \sigma_{LOi})$$
$$BB_{corr,q} = (1 + \varepsilon_{BB} + \varepsilon_{LO}) \cdot \sin(\omega_{BB} \cdot t + \Delta\phi_{BB} + \Delta\phi_{LO}) - (\delta_{BBq} + \sigma_{LOq}) \quad (12)$$

As these formulas include a phase shift, this correction is preferably done in the frequency domain, e.g. prior to the IFFT of the OFDM modulation.

A correction in the time domain is also possible, provided that the baseband quadrature errors are not (or only minor) frequency-dependent. The following equations apply:

$$BB_{corr,i} = (1 - \varepsilon_{BB} - \varepsilon_{LO}) \cdot BB_I + (\Delta\phi_{BB} + \Delta\phi_{LO}) \cdot BB_Q - (\delta_{BBi} + \sigma_{LOi})$$
$$BB_{corr,q} = (1 + \varepsilon_{BB} + \varepsilon_{LO}) \cdot BB_Q + (\Delta\phi_{BB} + \Delta\phi_{LO}) \cdot BB_I - (\delta_{BBq} + \sigma_{LOq}) \quad (13)$$

and a block diagram for this implementation is shown in Fig. 9.

These formulas are of course linear approximations with respect to all other errors in the circuit. They are however only:

- second-order dependent on $\varepsilon_{BB}$ and $\Delta\phi_{BB}$.
- third-order dependent on $\varepsilon_{LF}$ and $\Delta\phi_{LF}$.
- second-order dependent on $\varepsilon_{FB}$ and $\Delta\phi_{FB}$.
- third-order dependent on $\varepsilon_{RC}$ and $\Delta\phi_{RC}$.

which makes them certainly good enough for an improvement of around 20dB in image rejection.
Note that:

- Although perfectly valid with ideal mixer circuits, simulations with real-life implementations show a small systematic deviation from these results. E.g. the BB phase $\theta_{BB}$ seems to be not perfectly the same as the compensation needed in the measurements on step 2 and 3. This is however something that can be easily detected during simulations, and the algorithm can be adjusted for it.
- This technique might be expanded further to compensate other transmit non-idealities, the most important of which are of course non-linearities. If the RF feedback signal is taken not directly at the mixer output, but at the PA output just before the antenna, sufficient information should be present to detect and correct the nonlinear behavior of the PA.

In conclusion, the invention provides a.o. a method for measuring and correcting the RF output spectrum of a direct upconversion mixer. Amplitude and phase information of all the spectral components of the output signal is obtained by downconverting the RF signal back to baseband. However, unknown errors in the downconversion operation are avoided by re-using the transmit mixer as a downconverter An automatic calibration procedure is presented that explains all the measurements and calculations to be performed in order to obtain an accurate estimate of both the image rejection and the carrier feedthrough. This procedure could even be extended to include other analog non-idealities such as e.g. intermodulation distortion.

An automatic calibration procedure can be generally described as a method for calibrating a direct upconversion transmitter which comprises one or more of the following calibration steps:

- applying a sine wave baseband signal to both the I and Q branch as input signal and transferring it directly without upconversion to the output of the conversion circuitry and conducting a first measurement with the characteristic deriving means; swapping the input signals of the I and Q branch and conducting a second measurement with the characteristic deriving means; and deriving quadrature errors of the baseband signal from the first and second measurements;
- applying a zero baseband signal to both the I and Q branch, shortcircuiting the conversion circuitry and conducting a third measurement with the characteristic deriving means; swapping the sign of the second input signal and conducting a fourth measurement with the characteristic deriving means; and deriving a DC offset of the signal adding means from the third and fourth measurements;
- applying a single baseband tone to both the I and Q branch while the conversion circuitry is operational and the signal adding means are not operational and conducting a fifth measurement with the characteristic deriving means; swapping the output signals of the I and Q branches and conducting a sixth measurement with the characteristic deriving means; and deriving a DC offset of the conversion circuitry from the fifth and sixth measurements;
- applying a single baseband tone to both the I and Q branch while the conversion circuitry and the signal adding means are operational with a first phase shift on the second input signal, and conducting a seventh measurement with the characteristic deriving means; swapping the output signals of the I and Q branches and conducting an eighth measurement with the characteristic deriving means; applying a second phase shift to the second input signal and conducting a ninth measurement with the characteristic deriving means; swapping the output signals of the I and Q branches and conducting a tenth measurement with the characteristic deriving means; and deriving conversion circuitry quadrature errors and/or carrier feedthrough amplitude and/or carrier feedthrough phase from the seventh to tenth measurements.

## Claims

1. An electrical analog transmit device comprising analog conversion circuitry (3; 13) having an input and an output, the conversion circuitry being essentially provided for converting a first input signal within a first frequency range applied to its input (31) to an output signal within a second frequency range above the first frequency range at its output (32), the analog transmit device having a first circuit (1; 11) electrically connected to the input (31) and a second circuit (2; 12) electrically connected to the output (32) of the conversion circuitry, the first circuit (1; 11) being provided for supplying the first input signal and the second circuit (2; 12) being provided for transmitting a significant part of the output signal, **characterised in that** the device further comprises signal adding means (4-5; 15-19) for adding a portion of the output signal as second input signal to the first input signal, said signal adding means being formed by an electrical connection (4; 17-19) from the output (32) towards the input (31) of the conversion circuitry (3), said electrical connection comprising one or more filters (5; 15-16) for eliminating signals outside the second frequency range from the output signal to create said portion of the output signal which is added as the second input signal to the first input signal; that the conversion circuitry (3; 13) is capable of converting the second input signal back to the first frequency range and that characteristic deriving means (6-7; 20-21) are provided for deriving at least one characteristic of the electrical device from the frequency converted second input signal, the characteristic deriving means comprising an extraction circuit (6; 20-21) electrically connected to the output (32) of the conversion circuitry and being provided for extracting a first frequency range portion containing the frequency converted second input signal from the output signal.

2. The device of claim 1, **characterised in that** said electrical connection comprises a phase shifter (22) for invoking one of a plurality of predetermined phase shifts to the second input signal before being added to the first input signal.

3. The device of claim 2, **characterised in that** said phase shifter is an RC/CR block.

4. The device of any one of the claims 1-3, **characterised in that** the characteristic deriving means comprise a characterisation block (7) connected to the extraction circuit, the characterisation block being provided for supplying signal correction data to the first circuit.

5. The device of claim 4, **characterised in that** the device is an upconversion transmit device, the first circuit being formed by a baseband circuit (1) and the second circuit being formed by a radio frequent transmitting circuit (2), the conversion circuitry comprising at least one upconversion step (3) with a local oscillator and a mixer.

6. The device of any one of the claims 1-5, **characterised in that** the first and second circuits (11, 12) and the analog conversion circuitry (13) comprise a first branch for dealing with signals having a first phase and a second branch for dealing with signals having a second phase different from the first phase.

7. The device of claim 6, **characterised in that** the device is provided for I/Q modulation, the first branch defining the I branch and the second branch defining the Q branch.

8. A method for deriving at least one characteristic of an electrical analog transmit device having analog conversion circuitry (3; 13) which is essentially provided for performing a frequency conversion on a first input signal within a first frequency range to obtain an output signal within a second frequency range above the first frequency range, the method comprising the step of

(a) supplying the first input signal to the device and converting the first input signal to the output signal within the second frequency range by means of the analog conversion circuitry (3; 13),
**characterised in that** the method further comprises the steps of
(b) adding a portion of the output signal as a second input signal to the first input signal by means of signal adding means (4-5; 15-19), said signal adding means being formed by an alectrical connection (4; 17-19) from the output (32) towards the input (31) of the analog conversion circuitry (3; 13), said electrical connection comprising one or more filters (5; 15-16) for eliminating signals outside the second frequency range from the output signal to create said portion of the output signal which is added as the second input signal to the first input signal,
(c) converting the second input signal back to the first frequency range by means of the analog conversion circuitry (3; 13), thereby obtaining a frequency converted second input signal in the output signal, and
(d) extracting a first frequency range portion from the output signal and deriving at least one characteristic of the electrical analog transmit device from the frequency converted second input signal which is contained in said first frequency range portion extracted from the output signal.

9. The method of claim 8, **characterised in that** the method further comprises the steps of: (e) applying a predetermined phase shift to the second input signal before it is added to the first input signal, (f) deriving at least one characteristic of the electrical device from the frequency converted phase shifted second input signal which is contained in said first frequency range portion extracted from the output signal.

10. The method of any one of the claims 8-9, **characterised in that** said electrical device is provided for I/Q modulation and comprises an I branch and a Q branch, the first input signal being supplied to the I branch and a third input signal being supplied to the Q branch, the third input signal having a phase which is substantially orthogonal to the first input signal, the output signal being formed by a combination of the I branch output and the Q branch output of the conversion circuitry, the method further comprising the step (g) of splitting said portion of the output signal into the second input signal of step (b) and a fourth input signal which is added to the third input signal.

11. The method of any one of the claims 8-10, **characterised in that** said characteristics include at least one of the following: DC offsets, carrier feedthrough, quadrature imperfections, intermodulation distortion.

12. A method for precompensating an input signal of an electrical analog transmit device having analog conversion circuitry which is essentially provided for performing a frequency conversion on a first input signal within a first frequency range to obtain an output signal within a second frequency range above the first frequency range, the method comprising the steps of any one of the claims 8-11 for determining at least one device characteristic and the further steps of generating signal correction data from said determined at least one device characteristic by means of a characterisation block (7) and precompensating the input signal by means of the signal correction data.

13. The method of claim 12, **characterised in that** the precompensation step is performed in the digital domain.

## Patentansprüche

1. Elektrische analoge Sendevorrichtung, die eine Analogumwandlungsschaltung (3; 13) mit einem Eingang und einem Ausgang umfasst, wobei die Umwandlungsschaltung im Wesentlichen dafür vorgesehen ist, ein erstes Eingangssignal innerhalb eines ersten Frequenzbereichs, das in ihren Eingang (31) eingespeist wird, in ein Ausgangssignal innerhalb eines zweiten Frequenzbereichs oberhalb des ersten Frequenzbereichs an ihrem Ausgang (32) umzuwandeln, wobei die analoge Sendevorrichtung einen ersten Schaltkreis (1; 11) aufweist, der elektrisch mit dem Eingang (31) der Umwandlungsschaltung verbunden ist, und einen zweiten Schaltkreis (2; 12) aufweist, der elektrisch mit dem Ausgang (32) der Umwandlungsschaltung verbunden ist, wobei der erste Schaltkreis (1; 11) dazu dient, das erste Eingangssignal bereitzustellen, und der zweite Schaltkreis (2; 12) dazu dient, einen signifikanten Teil des Ausgangssignals zu übertragen, **dadurch gekennzeichnet, dass**: die Vorrichtung des Weiteren ein Signaladdiermittel (4-5; 15-19) umfasst, um einen Abschnitt des Ausgangssignals als zweites Eingangssignal zu dem ersten Eingangssignal zu addieren, wobei das Signaladdiermittel durch eine elektrische Verbindung (4; 17-19) von dem Ausgang (32) in Richtung des Eingangs (31) der Umwandlungsschaltung (3) gebildet wird, wobei die elektrische Verbindung einen oder mehrere Filter (5; 15-16) umfasst, um Signale, die außerhalb des zweiten Frequenzbereichs liegen, aus dem Ausgangssignal zu löschen, um den Abschnitt des Ausgangssignals zu erzeugen, der als das zweite Eingangssignal zu dem ersten Eingangssignal addiert wird; dass die Umwandlungsschaltung (3; 13) in der Lage ist, das zweite Eingangssignal zu dem ersten Frequenzbereich zurück umzuwandeln, und dass ein Kennlinienableitungsmittel (6-7; 20-21) bereitgestellt ist, um mindestens eine Kennlinie der elektrischen Vorrichtung aus der frequenzkonvertierten zweiten Eingangssignal abzuleiten, wobei das Kennlinienableitungsmittel einen Extraktionsschaltkreis (6; 20-21) umfasst, der elektrisch mit dem Ausgang (32) der Umwandlungsschaltung verbunden ist und dazu dient, einen ersten Frequenzbereichsabschnitt, der das frequenzkonvertierte zweite Eingangssignal enthält, aus dem Ausgangssignal zu extrahieren.

2. Vorrichtung nach Anspruch 1, **dadurch gekennzeichnet, dass** die elektrische Verbindung umfasst einen Phasenschieber (22), um eine von mehreren vorgegebenen Phasenverschiebungen an dem zweiten Eingangssignal aufzurufen, bevor es zu dem ersten Eingangssignal addiert wird.

3. Vorrichtung nach Anspruch 2, **dadurch gekennzeichnet, dass** der Phasenschieber ein RC/CR-Block ist.

4. Vorrichtung nach einem der Ansprüche 1-3, **dadurch gekennzeichnet, dass** das Kennlinienableitungsmittel einen Charakterisierungsblock (7) umfasst, der an den Extraktionsschaltkreis angeschlossen ist, wobei der Charakterisierungsblock dazu dient, Signalkorrekturdaten in den ersten Schaltkreis einzuspeisen.

5. Vorrichtung nach Anspruch 4, **dadurch gekennzeichnet, dass** die Vorrichtung eine Aufwärtskonvertierungs-Sendevorrichtung ist, wobei der erste Schaltkreis durch einen Basisbandschaltkreis (1) gebildet wird und der zweite Schaltkreis durch einen Hochfrequenzsendeschaltkreis (2) gebildet, wobei die Umwandlungsschaltung mindestens eine Aufwärtskonvertierungsstufe (3) mit einem Überlagerungsoszillator und einem Mischer umfasst.

6. Vorrichtung nach einem der Ansprüche 1-5, **dadurch gekennzeichnet, dass** der erste und der zweite Schaltkreis (11, 12) und die Analogumwandlungsschaltung (13) einen ersten Abzweig für den Umgang mit Signalen mit einer ersten Phase und einen zweiten Abzweig für den Umgang mit Signalen mit einer zweiten Phase, die von der ersten Phase verschieden ist, bilden.

7. Vorrichtung nach Anspruch 6, **dadurch gekennzeichnet, dass** die Vorrichtung für eine I/Q-Modulation vorgesehen ist, wobei der erste Abzweig den I-Abzweig definiert und der zweite Abzweig den Q-Abzweig definiert.

8. Verfahren zum Ableiten mindestens einer Kennlinie einer elektrischen analogen Sendevorrichtung mit einer Analogumwandlungsschaltung (3; 13), die im Wesentlichen dafür vorgesehen ist, eine Frequenzumwandlung an einem ersten Eingangssignal innerhalb eines ersten Frequenzbereichs auszuführen, um ein Ausgangssignal innerhalb eines zweiten Frequenzbereichs oberhalb des ersten Frequenzbereichs zu erhalten, wobei das Verfahren folgenden Schritt umfasst:

   (a) Einspeisen des ersten Eingangssignals in die Vorrichtung und Umwandeln des ersten Eingangssignals in das Ausgangssignal innerhalb des zweiten Frequenzbereichs mittels der Analogumwandlungsschaltung (3; 13), **dadurch gekennzeichnet, dass** das Verfahren des Weiteren folgende Schritte umfasst:
   (b) Addieren eines Abschnitts des Ausgangssignals als ein zweites Eingangssignal zu dem ersten Eingangssignal mittels des Signaladdiermittels (4-5; 15-19), wobei das Signaladdiermittel durch eine elektrische Verbindung (4; 17-19) von dem Ausgang (32) in Richtung des Eingangs (31) der Analogumwandlungsschaltung (3; 13) gebildet wird, wobei die elektrische Verbindung einen oder mehrere Filter (5; 15-16) umfasst, um Signale, die außerhalb des zweiten Frequenzbereichs liegen, aus dem Ausgangssignal zu löschen, um den Abschnitt des Ausgangssignals zu erzeugen, der als das zweite Eingangssignal zu dem ersten Eingangssignal addiert wird;
   (c) Umwandeln des zweiten Eingangssignals zurück zu dem ersten Frequenzbereich mittels der Analogumwandlungsschaltung (3; 13), wodurch ein frequenzkonvertiertes zweites Eingangssignal in dem Ausgangssignal erhalten wird, und
   (d) Extrahieren eines ersten Frequenzbereichsabschnitts aus dem Ausgangssignal und Ableiten mindestens einer Kennlinie der elektrischen analogen Sendevorrichtung aus dem frequenzkonvertierten zweiten Eingangssignal, das in dem ersten Frequenzbereichsabschnitt enthalten ist, der aus dem Ausgangssignal extrahiert wurde.

9. Verfahren nach Anspruch 8, **dadurch gekennzeichnet, dass** das Verfahren des Weiteren folgende Schritte umfasst: (e) Anwenden einer vorgegebenen Phasenverschiebung auf das zweite Eingangssignal, bevor es zu dem ersten Eingangssignal addiert wird, (f) Ableiten mindestens einer Kennlinie der elektrischen Vorrichtung aus dem frequenzkonvertierten, phasenverschobenen zweiten Eingangssignal, das in dem ersten Frequenzbereichsabschnitt enthalten ist, der aus dem Ausgangssignal extrahiert wurde.

10. Verfahren nach einem der Ansprüche 8-9, **dadurch gekennzeichnet, dass** die elektrische Vorrichtung für eine I/Q-Modulation vorgesehen ist und einen I-Abzweig und einen Q-Abzweig umfasst, wobei das erste Eingangssignal in den I-Abzweig eingespeist wird und ein drittes Eingangssignal in den Q-Abzweig eingespeist wird, wobei das dritte Eingangssignal eine Phase aufweist, die im Wesentlichen orthogonal zu dem ersten Eingangssignal verläuft, wobei das Ausgangssignal durch eine Kombination des Ausgangs des I-Abzweigs und des Ausgangs des Q-Abzweigs der Umwandlungsschaltung gebildet wird, wobei das Verfahren des Weiteren folgenden Schritt (g) umfasst: Teilen des Abschnitts des Ausgangssignals in das zweite Eingangssignal von Schritt (b) und ein viertes Eingangssignal, das zu dem dritten Eingangssignal addiert wird.

11. Verfahren nach einem der Ansprüche 8-10, **dadurch gekennzeichnet, dass** die Kennlinien mindestens eines von Folgendem enthalten: DC-Versatzwerte, Trägerdurchführung, Quadraturfehler und Intermodulationsverzerrung.

12. Verfahren zum Vorkompensieren eines Eingangssignals einer elektrischen analogen Sendevorrichtung mit einer Analogumwandlungsschaltung, die im Wesentlichen zum Ausführen einer Frequenzumwandlung an einem ersten Eingangssignal innerhalb eines ersten Frequenzbereichs dient, um ein Ausgangssignal innerhalb eines zweiten Frequenzbereichs oberhalb des ersten Frequenzbereichs zu erhalten, wobei das Verfahren die Schritte nach einem der Ansprüche 8-11 zum Bestimmen mindestens einer Kennlinie der Vorrichtung und die weiteren Schritte des Erzeugens von Signalkorrekturdaten anhand der bestimmten, mindestens einen Vorrichtungskennlinie mittels eines Charakterisierungsblocks (7) und des Vorkompensierens des Eingangssignals mittels der Signalkorrekturdaten umfasst.

**13.** Verfahren nach Anspruch 12, **dadurch gekennzeichnet, dass** der Vorkompensationsschritt im digitalen Bereich ausgeführt wird.

**Revendications**

**1.** Dispositif électrique de transmission analogique comprenant une circuiterie de conversion analogique (3 ; 13) ayant une entrée et une sortie, la circuiterie de conversion étant essentiellement prévue pour convertir un premier signal d'entrée dans une première plage de fréquence appliqué à son entrée (31) en un signal de sortie dans une deuxième plage de fréquence au-dessus de la première plage de fréquence à sa sortie (32), le dispositif de transmission analogique ayant un premier circuit (1 ; 11) électriquement connecté à l'entrée (31 ) et un deuxième circuit (2 ; 12) électriquement connecté à la sortie (32) de la circuiterie de conversion, le premier circuit (1 ; 11) étant prévu pour fournir le premier signal d'entrée et le deuxième circuit (2 ; 12) étant prévu pour transmettre une partie significative du signal de sortie, **caractérisé en ce que** le dispositif comprend en outre des moyens d'addition des signaux (4 - 5 ; 15 - 19) pour ajouter une partie du signal de sortie comme deuxième signal d'entrée au premier signal d'entrée, lesdits moyens d'addition de signaux étant formés par une connexion électrique (4 ; 17 - 19) de la sortie (32) vers l'entrée (31) de la circuiterie de conversion (3), ladite connexion électrique comprenant un ou plusieurs filtres (5 ; 15 - 16) pour éliminer des signaux extérieurs à la deuxième plage de fréquence du signal de sortie pour créer ladite partie du signal de sortie qui est ajoutée comme le deuxième signal d'entrée au premier signal d'entrée, **en ce que** la circuiterie de conversion (3, 13) est capable de convertir le deuxième signal d'entrée pour le ramener dans la première plage de fréquence et **en ce que** des moyens de dérivation de caractéristiques (6 - 7 ; 20 - 21) sont prévus pour dériver au moins une caractéristique du dispositif électrique du deuxième signal d'entrée converti en fréquence, les moyens de dérivation de caractéristiques comprenant un circuit d'extraction (6 ; 20 - 21) électriquement connecté à la sortie (32) de la circuiterie de conversion et étant prévu pour extraire une première partie de plage de fréquence contenant le deuxième signal d'entrée converti en fréquence du signal de sortie.

**2.** Dispositif de la revendication 1, **caractérisé en ce que** ladite connexion électrique comprend un déphaseur (22) pour appeler un d'une pluralité de déphasages déterminés du deuxième signal d'entrée avant d'être ajouté au premier signal d'entrée.

**3.** Dispositif de la revendication 2, **caractérisé en ce que** ledit déphaseur est un bloc RC/CR.

**4.** Dispositif de l'une quelconque des revendications 1 - 3, **caractérisé en ce que** les moyens de dérivation de caractéristiques comprennent un bloc de caractérisation (7) connecté au circuit d'extraction, le bloc de caractérisation étant prévu pour fournir des données de correction de signal au premier circuit.

**5.** Dispositif de la revendication 4, **caractérisé en ce que** le dispositif est un dispositif de transmission à conversion ascendante, le premier circuit étant formé par un circuit à bande de base (1) et le deuxième circuit étant formé par un circuit de transmission à radiofréquence (2), la circuiterie de conversion comprenant au moins un étage de conversion ascendante avec un oscillateur local et un mixeur.

**6.** Dispositif de l'une quelconque des revendications 1 - 5, **caractérisé en ce que** les premier et deuxième circuits (11, 12) et la circuiterie de conversion analogique (13) comprennent une première branche pour traiter des signaux ayant une première phase et une deuxième branche pour traiter des signaux ayant une deuxième phase différente de la première phase.

**7.** Dispositif de la revendication 6, **caractérisé en ce que** le dispositif est prévu pour la modulation I/Q, la première branche définissant la branche I et la deuxième branche définissant la branche Q.

**8.** Procédé de dérivation d'au moins une caractéristique d'un dispositif électrique de transmission analogique ayant une circuiterie de conversion analogique (3 ; 13) qui est essentiellement prévue pour effectuer une conversion de fréquence sur un premier signal d'entrée dans une première plage de fréquence pour obtenir un signal de sortie dans une deuxième plage de fréquence au-dessus de la première plage de fréquence, le procédé comprenant l'étape consistant à

(a) fournir le premier signal d'entrée au dispositif et convertir le premier signal d'entrée en signal de sortie dans la deuxième plage de fréquence au moyen de la circuiterie de conversion analogique (3 ; 13), **caractérisé en ce que** le procédé comprend en outre les étapes consistant à

(b) ajouter une partie du signal de sortie comme un deuxième signal d'entrée au premier signal d'entrée à l'aide des moyens d'addition de signaux (4 - 5 ; 15 - 19), lesdits moyens d'addition de signaux étant formés par une connexion électrique (4 ; 17 - 19) de la sortie (32) vers l'entrée (31) de la circuiterie de conversion analogique (3 ; 13), ladite connexion électrique comprenant un ou plusieurs filtres (5 ; 15 - 16) pour éliminer des signaux extérieurs à la deuxième plage de fréquence du signal de sortie pour créer ladite partie du signal de sortie qui est ajoutée comme le deuxième signal d'entrée au premier signal d'entrée,

(c) convertir le deuxième signal d'entrée pour le ramener dans la première plage de fréquence au moyen de la circuiterie de conversion analogique (3 ; 13), obtenant ainsi un deuxième signal d'entrée converti en fréquence dans le signal de sortie et

(d) extraire une première partie de plage de fréquence du signal de sortie et dériver au moins une caractéristique du dispositif électrique de transmission analogique du deuxième signal d'entrée converti en fréquence qui est contenu dans ladite première partie de plage de fréquence extraite du signal de sortie.

9.  Procédé de la revendication 8, **caractérisé en ce que** le procédé comprend en outre les étapes consistant à : (e) appliquer un déphasage prédéterminé au deuxième signal d'entrée avant qu'il ne soit ajouté au premier signal d'entrée, (f) dériver au moins une caractéristique du dispositif électrique du deuxième signal d'entrée déphasé converti en fréquence qui est contenu dans ladite première partie de plage de fréquence extraite du signal de sortie.

10. Procédé de l'une quelconque des revendications 8 - 9, **caractérisé en ce que** ledit dispositif électrique est prévu pour la modulation I/Q et comprend une branche I et une branche Q, le premier signal d'entrée étant fourni à la branche I et un troisième signal d'entrée étant fourni à la branche Q, le troisième signal d'entrée ayant une phase qui est sensiblement orthogonale au premier signal d'entrée, le signal de sortie étant formé par une combinaison de la sortie de la branche I et de la sortie de la branche Q de la circuiterie de conversion, le procédé comprenant en outre l'étape (g) consistant à diviser cette partie du signal de sortie en le deuxième signal d'entrée de l'étape (b) et un quatrième signal d'entrée qui est ajouté au troisième signal d'entrée.

11. Procédé de l'une quelconque des revendications 8 - 10, **caractérisé en ce que** lesdites caractéristiques comprennent au moins un de ce qui suit : décalages CC, diaphonie de la porteuse, imperfections de quadrature, distorsion d'intermodulation.

12. Procédé de précompensation d'un signal d'entrée d'un dispositif électrique de transmission analogique ayant une circuiterie de conversion analogique qui est essentiellement prévue pour effectuer une conversion de fréquence sur un premier signal d'entrée dans une première plage de fréquence pour obtenir un signal de sortie dans une deuxième plage de fréquence au-dessus de la première plage de fréquence, le procédé comprenant les étapes de l'une quelconque des revendications 8 - 11 pour déterminer au moins une caractéristique du dispositif et les autres étapes de génération de données de correction de signal à partir de ladite au moins une caractéristique de dispositif déterminée au moyen d'un bloc de caractérisation (7) et précompenser le signal d'entrée au moyen des données de correction de signal.

13. Procédé de la revendication 12, **caractérisé en ce que** l'étape de précompensation est effectuée dans le domaine numérique.

**Fig. 1**

**Fig. 2**

Fig. 3 (prior art)

Fig. 4 (prior art)

**Fig. 5**

**Fig. 6**

**Fig. 7**

**Fig. 8**

**Fig. 9**

**Fig. 10**

**Fig. 11**

**Fig. 12**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0477720 A
- WO 00159171 A
- EP 1172928 A
- US 5918167 A
- EP 1047185 A

### Non-patent literature cited in the description

- **M. Faulkner ; T. Mattsson ; W. Yates.** Automatic adjustment of quadrature modulators. *IEE Electronic Letters,* January 1991, vol. 27 (3), 214-215
- **D. Hilborn ; S. Stapleton ; J. Cavers.** An adaptive direct conversion transmitter. *IEEE Trans. On Vehicular Technology,* May 1994, vol. 43 (2), 223-233